Europäisches Patentamt

European Patent Office

Office européen des brevets

(11) Numéro de publication : **0 065 901**
**B1**

# FASCICULE DE BREVET EUROPÉEN

(45) Date de publication du fascicule du brevet :
**09.01.85**

(51) Int. Cl.⁴ : **G 01 R 15/10**

(21) Numéro de dépôt : **82400841.1**

(22) Date de dépôt : **07.05.82**

(54) **Système potentiométrique perfectionné.**

(30) Priorité : **27.05.81 FR 8110513**

(43) Date de publication de la demande :
**01.12.82 Bulletin 82/48**

(45) Mention de la délivrance du brevet :
**09.01.85 Bulletin 85/02**

(84) Etats contractants désignés :
**DE FR GB**

(56) Documents cités :
**DE-A- 2 549 995**
**FR-A- 2 311 277**

(73) Titulaire : **SOCIETE NATIONALE D'ETUDE ET DE CONSTRUCTION DE MOTEURS D'AVIATION, "S.N.E.C.M.A."**
**2 Boulevard Victor**
**F-75015 Paris (FR)**

(72) Inventeur : **Corral, José Romain**
**44, allée de Beaudedit Résidence de Germenoy**
**F-77530 Vaux le Penil (FR)**

(74) Mandataire : **Moinat, François et al**
**S.N.E.C.M.A. Service des Brevets Boîte Postale 81**
**F-91003 Evry Cedex (FR)**

Jouve, 18, rue St-Denis, 75001 Paris, France

0 065 901

### Description

La présente invention a pour objet un système potentiométrique perfectionné pour convertir la position d'un organe mobile en une grandeur électrique C qui varie selon une loi f prédéterminée entre une valeur minimale $C_{min}$ et une valeur maximale $C_{max}$ prédéterminées, lorsque l'organe mobile est déplacé d'une première à une seconde position extrême, ledit organe mobile étant lié au curseur d'un potentiomètre mécanique qui délivre un premier signal d'amplitude x variable en fonction de la position de l'organe mobile.

Les potentiomètres mécaniques usuels fournissent une tension de sortie qui varie en fonction de la position du curseur généralement suivant une loi linéaire ou encore logarithmique directe ou inverse.

Pour réaliser un potentiomètre offrant une loi de variation quelconque autre que linéaire ou logarithmique, on peut concevoir une piste résistive spéciale le long de laquelle le curseur se déplace ou encore un dispositif potentiométrique tel que celui décrit dans la demande de brevet FR-A-2 311 277. Il s'ensuit toutefois un coût de fabrication élevé et une impossibilité de modifier simplement la loi de variation. De plus, lorsque plusieurs pistes avec des lois de variations différentes doivent être calées les unes par rapport aux autres, ceci ne peut se faire que dans un même potentiomètre pour des raisons de stabilité et de précision, ce qui complique encore la construction et augmente le prix de revient.

Aussi, la présente invention a pour but de fournir un système potentiométrique qui ne présente pas ces inconvénients en particulier un système potentiométrique permettant, avec un prix de revient faible, d'obtenir toute loi de variation désirée avec possibilité de modifier facilement cette loi de variation et, le cas échéant, de caler l'un par rapport à l'autre plusieurs systèmes potentiométriques ayant des lois de variation différentes.

Plus particulièrement, la présente invention a pour but d'obtenir toute loi de variation désirée à partir d'un potentiomètre mécanique usuel, par exemple linéaire, sans modifier la piste de ce potentiomètre.

Ce but est atteint au moyen d'un système potentiométrique tel que défini en tête de la présente description et dans lequel, conformément à l'invention :

— un premier circuit de transformation reçoit ledit premier signal d'amplitude x pour le convertir en un second signal dont une caractéristique varie en fonction de x suivant ladite loi f prédéterminée entre une valeur minimale k et une valeur maximale K lorsque l'organe mobile est déplacé de sa première à sa seconde position, et

— un second circuit de transformation reçoit ledit second signal et deux signaux représentatifs des valeurs $C_{min}$ et $C_{max}$ pour délivrer ladite grandeur

$$C = C_{min} + \ [(C_{max} - C_{min})/(K - k)] \ [f(x) - k].$$

Selon une particularité du système potentiométrique conforme à l'invention, le premier circuit de transformation comporte des moyens pour maintenir à la valeur k ladite caractéristique du second signal lorsque l'organe mobile est déplacé dans une plage comprise entre sa première position extrême et une première position intermédiaire. De façon similaire, on peut prévoir des moyens pour maintenir à la valeur K ladite caractéristique du second signal lorsque l'organe mobile est déplacé dans une plage comprise entre une seconde position intermédiaire et sa seconde position extrême. Ainsi, on peut limiter la plage utile de position de l'organe mobile, c'est-à-dire celle dans laquelle une variation de position se traduit par une variation de la grandeur de sortie, entre deux positions intermédiaires distinctes des positions extrêmes. Avantageusement, le premier circuit de transformation comporte des moyens pour ajuster l'emplacement de ces positions intermédiaires.

Selon une autre particularité du système potentiométrique conforme à l'invention, l'amplitude d'au moins l'un des signaux $C_{min}$ et $C_{max}$ est variable. Ainsi, l'allure de variation de la grandeur de sortie est définie par le premier circuit de transformation, tandis que l'amplitude maximale de variation de cette grandeur de sortie ainsi que ses valeurs limites sont définies par le second circuit de transformation et sont ajustables.

Selon encore une autre particularité du système potentiométrique conforme à l'invention, le second signal délivré par le premier circuit de transformation est une suite d'impulsions et ladite caractéristique variable en fonction de la position de l'organe mobile est le rapport cyclique desdites impulsions.

D'autres particularités et avantages du système potentiométrique conforme à l'invention ressortiront à la lecture de la description faite ci-après, à titre indicatif mais non limitatif, en référence aux dessins joints sur lesquels :

la figure 1   est une vue schématique d'un mode de réalisation d'un système potentiométrique selon l'invention,

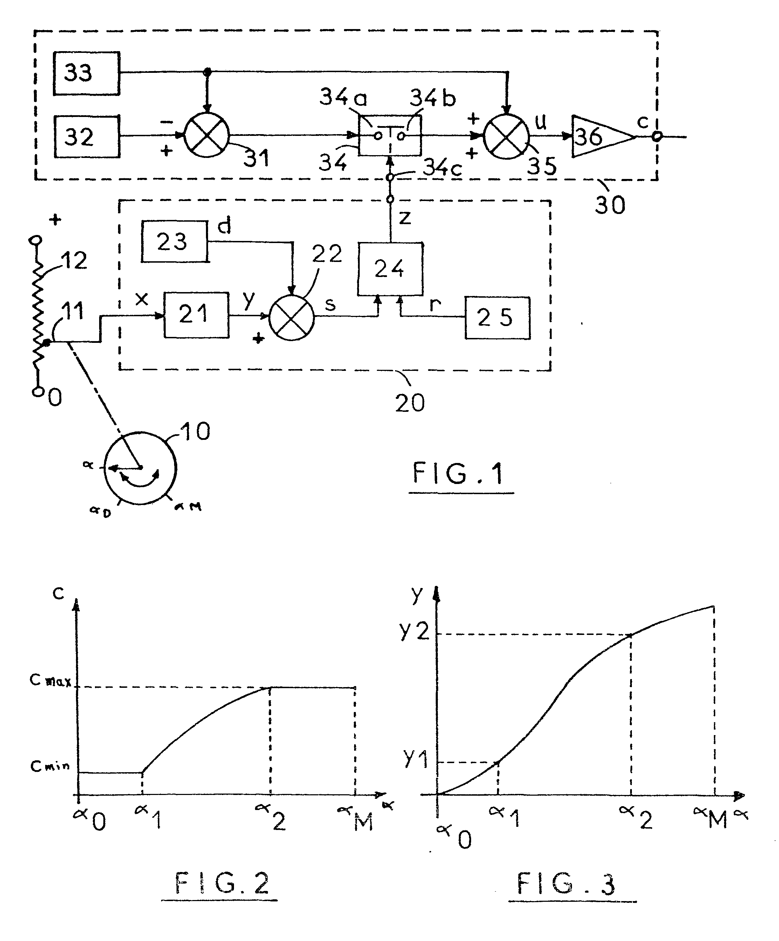

la figure 2   montre la variation de la grandeur de sortie du système potentiométrique de la figure 1 en fonction de la position de l'organe mobile de ce système potentiométrique,

la figure 3   montre la variation d'un signal en un point du premier circuit de transformation du système potentiométrique de la figure 1 en fonction de la position de l'organe mobile de ce système potentiométrique,

la figure 4 à 7   montrent chacune les signaux produits en différents points du premier et du second

2

0 065 901

circuit de transformation du système potentiométrique de la figure 1 lorsque l'organe mobile occupe une position particulière,

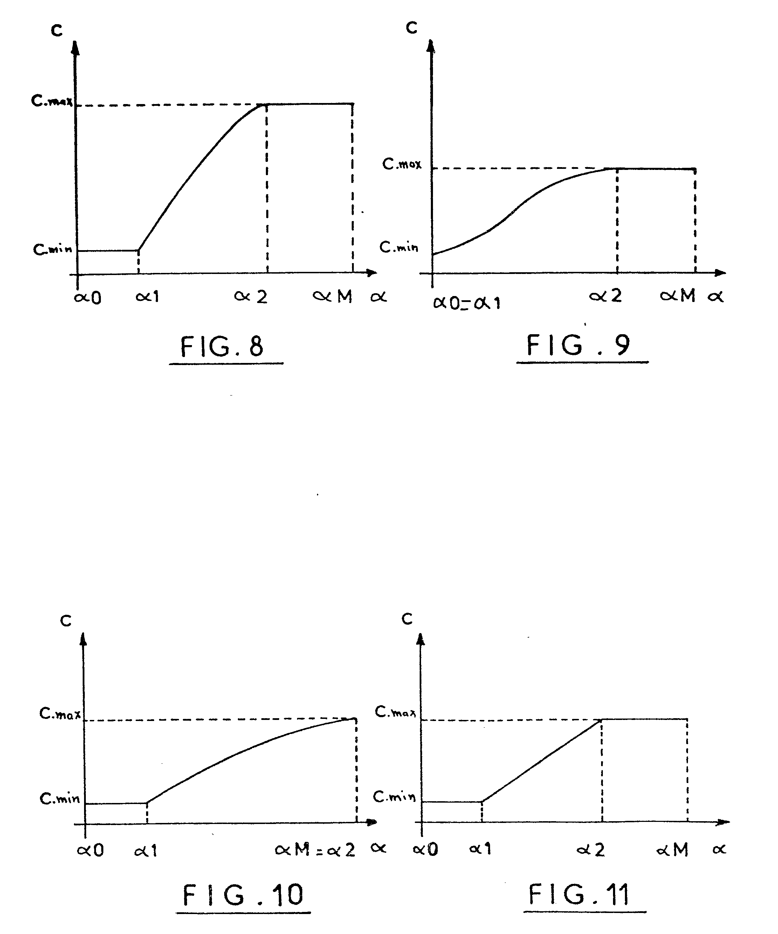

les figures 8 à 11 montrent des variations différentes de la grandeur de sortie suivant des modes différents de mise en œuvre du système potentiométrique de la figure 1.

Sur la figure 1, la référence 10 désigne un organe de réglage dont la position peut varier, par exemple par rotation, entre deux limites extrêmes $\alpha_0$ et $\alpha_M$. L'organe de réglage 10 est lié à un curseur 11 d'un potentiomètre mécanique résistif 12. L'amplitude x de la tension disponible au curseur du potentiomètre 12 varie de la valeur minimale $x_0$ à une valeur maximale $x_M$ lorsque le bouton de réglage 10 est déplacé de sa position $\alpha_0$ à sa position $\alpha_M$.

La tension x est appliquée à l'entrée d'un premier circuit de transformation 20. Celui-ci comporte un générateur de fonction 21 qui reçoit la tension x et délivre un signal $y = h(x)$, h étant une fonction définie plus loin. Le signal y est appliqué à une entrée d'un additionneur 22 recevant sur une autre entrée un signal en dents de scie d fourni par un générateur 23. En sortie de l'additionneur 22 est disponible un signal somme $s = y + d$. Ce signal somme s est appliqué à une entrée d'un comparateur 24 dont une autre entrée reçoit une tension de référence r fournie par une source de tension continue réglable 25. Lorsque le signal s est inférieur ou égal à la tension r la tension z en sortie du comparateur 24 a une valeur nulle. Par contre, lorsque le signal s est supérieur à la tension r, la tension z en sortie du comparateur 24 a une valeur positive non nulle V1. La sortie du comparateur 24 constitue la sortie du circuit 20.

Un second circuit de transformation 30 comporte un circuit soustracteur 31 dont une première entrée est reliée à une source de tension continue ajustable 32 fournissant une tension $C_{max}$ et la seconde entrée est reliée à une autre source de tension continue ajustable 33 fournissant une tension $C_{min}$. La sortie du circuit soustracteur 31 est reliée à une borne 34a d'un circuit interrupteur 34 pour appliquer à cette borne la tension $C_{max} - C_{min}$. L'autre borne 34b du circuit interrupteur 34 est reliée à une première entrée d'un circuit additionneur 35 dont une deuxième entrée est reliée à la source 33 et dont la sortie est reliée à l'entrée d'un circuit intégrateur 36. L'interrupteur 34 a une borne de commande 34c reliée à la sortie du circuit 20. La fermeture de l'interrupteur 34 est commandée par le signal de sortie du circuit 20 lorsque ce signal a sa valeur positive V1. La sortie de l'intégrateur 36 constitue la sortie du circuit 30 et celle du sytème potentiométrique où la grandeur C est disponible.

Le fonctionnement du système potentiométrique décrit ci-dessus est le suivant.

On suppose que l'on veut convertir la coordonnée angulaire (ou linéaire) $\alpha$ de l'organe mobile en une tension électrique C telle que représentée sur la figure 2 et qui peut être exprimée sous la forme suivante :

$C = f(x)$ avec
$f(x) = C_{min}$ lorsque $\alpha_0 \leqslant \alpha \leqslant \alpha_1$
$f(x) = C_{min} + (C_{max} - C_{min})\, f'(\alpha)$ lorsque $\alpha_1 < \alpha < \alpha_2$ et
$f(x) = C_{max}$ lorsque $\alpha_2 \leqslant \alpha \leqslant \alpha_M$,

$\alpha_1$ et $\alpha_2$ étant les coordonnées de positions intermédiaires de l'organe mobile entre ses positions extrêmes $\alpha_0$ et $\alpha_M$ (la tension x étant définie ci-dessous).

La fonction f' est choisie selon les besoins ; elle exprime les variations souhaitées de la grandeur C lorsque la position angulaire de l'organe mobile varie dans la plage « utile »... $]\alpha_1, \alpha_2[$ ... On décrira ci-après comment les positions $\alpha_1$ et $\alpha_2$ peuvent être le cas échéant ajustées.

La tension x est une fonction $g(\alpha)$ de la coordonnée $\alpha$ de l'organe mobile 10· telle que $g(\alpha) = x_0$ lorsque $\alpha = \alpha_0$ et $g(\alpha) = x_M$ lorsque $\alpha = \alpha_M$. On pourra choisir un potentiomètre linéaire 12 donnant $x = k(\alpha - \alpha_0)$, k étant une constante. On a alors $x_0 = 0$ et $x_M = k(\alpha_M - \alpha_0)$.

La tension x est transformée par le générateur de fonction 21 en une tension $y = f''(\alpha)$.

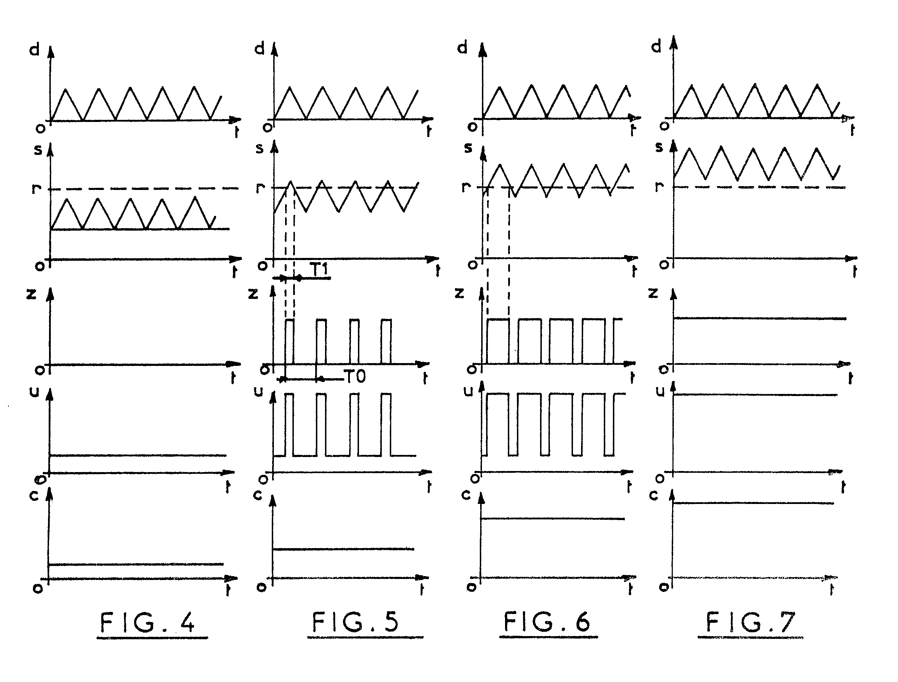

La figure 3 illustre les variations de y en fonction de la coordonnée $\alpha$. Chacune des figures 4 à 7 illustre notamment les variations en fonction du temps des signaux d, s et z pour une valeur particulière de $\alpha$. Pour les figures 4 à 7, on a choisi des valeurs $\alpha_4, \alpha_5, \alpha_6, \alpha_7$ telles que

$$\alpha_0 < \alpha_4 < \alpha_1 \; ; \; \alpha_1 < \alpha_5 < \alpha_6 < \alpha_2 \text{ et } \alpha_2 < \alpha_7 < \alpha_M.$$

La tension y varie sans décroître entre une valeur minimale $y_0$ et une valeur maximale $y_M$ lorsque $\alpha$ varie de $\alpha_0$ à $\alpha_M$.

On désigne par $d_M$ l'amplitude maximale du signal en dents de scie d et par $d_0$ l'amplitude minimale de ce signal. On choisit alors la valeur de référence r et les valeurs $d_M$ et $d_0$ telles que :

$$r = d_M + y_1 = d_0 + y_2$$

$y_1$ étant la valeur de y lorsque $\alpha = \alpha_1$ et $y_2$ étant la valeur de y lorsque $\alpha = \alpha_2$.

Ainsi, tant que $\alpha_0 < \alpha < \alpha_1$ (figure 4), le signal somme s n'excède pas la valeur de référence r et le signal z reste nul.

Par ailleurs, tant que $\alpha_2 < \alpha < \alpha_M$ (figure 7), le signal s excède la valeur de référence r et le signal z reste constamment égal à la valeur V1.

Enfin, lorsque $\alpha$ est compris entre $\alpha_1$ et $\alpha_2$, (figures 5 et 6), la sortie du comparateur 24 passe de 0 à V1 au cours d'une fraction de chaque période T0 du signal d. Le signal z en sortie du comparateur a donc

3

la forme d'une suite d'impulsions dont la largeur T1 est d'autant plus grande que l'amplitude du signal y est plus élevée. Si l'on désigne par $\tau$ le rapport cyclique des impulsions alors produites par le circuit 20, on a

$$\tau = (T1/T0) = [(d_M + y - r)/(d_M - d_0)] = [(y - y_1)/(y_2 - y_1)]$$

Le signal z commande la fermeture de l'interrupteur 34 lorsqu'il est au niveau V1. L'additionneur 35 reçoit, d'une part, le signal $C_{min}$ et, d'autre part, le signal $C_{max} - C_{min}$ pendant les périodes de fermeture de l'interrupteur 34.

Le signal u délivré par l'additionneur 35 et le signal C sont représentés sur les figures 4 à 7.

Lorsque $\alpha_0 < \alpha < \alpha_1$, l'additionneur 35 ne reçoit que $C_{min}$ et la valeur moyenne du signal de sortie de cet additionneur reste égale à $C_{min}$.

Lorsque $\alpha_2 < \alpha < \alpha_M$, l'additionneur 35 reçoit d'une part, $C_{min}$ et, d'autre part, en permanence, $C_{max} - C_{min}$. La valeur moyenne du signal de sortie reste donc égale à $C_{max}$.

Enfin, lorsque $\alpha_1 < \alpha < \alpha_2$, l'additionneur 35 reçoit, d'une part, $C_{min}$ et, d'autre part, $C_{max} - C_{min}$ uniquement pendant les périodes T1. La valeur moyenne du signal de sortie est donc égale à $C_{min} + \tau(C_{max} - C_{min})$, $\tau$ variant entre 0 et 1. Cette valeur moyenne est bien égale à la valeur C recherchée dans la mesure où

$$\tau = (y - y_1)/(y_2 - y_1) = f'(\alpha), \text{ c'est-à-dire}$$
$$y = f''(\alpha) = (y_2 - y_1) f'(\alpha) + y_1$$

Les fonctions f″ et f′ sont donc de même nature. Connaissant la fonction f″. on détermine la fonction h du générateur de fonction 21 telle que $h(x) = h[g(\alpha)] = f''(\alpha)$ ; c'est-à-dire $h = f'' \cdot g^{-1}$ ; $g^{-1}$ étant la fonction inverse de g.

L'ensemble du système potentiométrique illustré par la figure 1 étant défini, certaines modifications peuvent être apportées très facilement à la fonction f(x) régissant la valeur de la grandeur de sortie C :

— les valeurs extrêmes $C_{max}$ et $C_{min}$ de la grandeur C peuvent être modifiées en agissant sur les sources de tension continues 32. 33 lesquelles peuvent être simplement réalisées au moyen de diviseurs de tension potentiométriques branchés aux bornes d'une source de tension continue constante,

— la limite supérieure $\alpha_2$ de la plage utile de variation de l'organe mobile 10 peut être réglée en agissant sur la source de tension continue 25 qui peut être réalisée au moyen d'un diviseur de tension potentiométrique ; on a en effet $y_2 = f''(\alpha_2) = r - d_0$ ; la valeur minimale $d_0$ de la tension en dents de scie étant fixe (par exemple nulle), $\alpha_2$ est déterminé par r ; $d_0$, r et $\alpha_2$ étant fixés, on peut ajuster la valeur $\alpha_1$, c'est-à-dire la plage de variation utile de l'organe mobile 11 en agissant sur l'amplitude totale $D = d_M - d_0$ de la tension en dents de scie ; on a en effet

$$y_1 = f''(\alpha_1) = r - d_M = r - D - d_0 \ ;$$

il suffit donc d'engendrer une tension en dents de scie $d_M$ d'amplitude $D_M$ supérieure au maximum que peut prendre la valeur D recherchée, d'appliquer cette tension $d_M$ aux bornes d'un diviseur de tension, par exemple potentiométrique, et de prélever la tension d au point milieu ajustable de ce diviseur.

Les modifications indiquées ci-dessus peuvent être faites très facilement. Les figures 8, 9, 10 montrent les résultats obtenus en agissant sur l'amplitude de variation $C_{max} - C_{min}$ de la grandeur de sortie, en modifiant la valeur $\alpha_2$ pour la rendre égale à $\alpha_M$ et en modifiant les valeurs $\alpha_1$ et $\alpha_2$ pour les rendre égales à $\alpha_0$ et $\alpha_M$ respectivement.

Lorsque l'on veut agir sur l'allure de variation de la grandeur C dans l'intervalle $]\alpha_1, \alpha_2[$, il est alors nécessaire de modifier le générateur de fonction 21. A noter qu'en utilisant un potentiomètre linéaire dont le curseur est connecté directement à l'additionneur 22, c'est-à-dire en court-circuitant le générateur de fonction 21 sur la figure 1, on obtient une grandeur de sortie qui varie linéairement entre $C_{min}$ et $C_{max}$ dans l'intervalle $]\alpha_1, \alpha_2[$, comme représenté sur la figure 11.

On notera encore que la réalisation de plusieurs systèmes potentiométriques calés l'un par rapport à l'autre peut être faite en associant des circuits 20 et 30 particuliers pour chaque système potentiométrique en fonction de la loi de variation désirée pour celui-ci, le potentiomètre mécanique 12 étant commun.

## Revendications

1. Système potentiométrique perfectionné pour convertir la position d'un organe mobile (10) en une grandeur électrique C qui varie selon une loi f prédéterminée entre une valeur minimale $C_{min}$ et une valeur maximale $C_{max}$ prédéterminées, lorsque l'organe mobile est déplacé d'une première à une seconde position extrême, ledit organe mobile étant lié au curseur (11) d'un potentiomètre mécanique (12) qui délivre un premier signal d'amplitude x variable en fonction de la position de l'organe mobile, caractérisé en ce qu'un premier circuit de transformation (20) reçoit ledit premier signal d'amplitude x pour le convertir en un second signal (z) dont une caractéristique varie en fonction de x suivant ladite loi f

4

prédéterminée entre une valeur minimale k et une valeur maximale K lorsque l'organe mobile est déplacé de sa première ($\alpha_0$) à sa seconde position ($\alpha_M$), et un second circuit de transformation (30) reçoit ledit second signal et deux signaux représentatifs des valeurs $C_{min}$ et $C_{max}$ pour délivrer ladite grandeur

$$C = C_{min} + [(C_{max} - C_{min})/(K - k)] \, [f(x) - k].$$

2. Système potentiométrique selon la revendication 1, caractérisé en ce que le premier circuit de transformation (20) comporte des moyens pour maintenir à la valeur nulle ladite caractéristique du second signal lorsque l'organe mobile (10) est déplacé dans une plage comprise entre sa première position extrême ($\alpha_0$) et une première position intermédiaire ($\alpha_1$).

3. Système potentiométrique selon l'une quelconque des revendications 1 à 3, caractérisé en ce que le premier circuit de transformation (20) comporte des moyens de réglage pour ajuster l'emplacement de ladite première position intermédiaire ($\alpha_1$).

4. Système potentiométrique selon l'une quelconque des revendications 1 à 3, caractérisé en ce que le premier circuit de transformation (20) comporte des moyens pour maintenir à la valeur K ladite caractéristique du second signal lorsque l'organe mobile (10) est déplacé dans une plage comprise entre une seconde position intermédiaire ($\alpha_2$) et sa seconde position extrême ($\alpha_M$).

5. Système potentiométrique selon la revendication 4, caractérisé en ce que le premier circuit de transformation (20) comporte des moyens de réglage pour ajuster l'emplacement de ladite seconde position intermédiaire ($\alpha_2$).

6. Système potentiométrique selon l'une quelconque des revendications précédentes, caractérisé en ce que l'amplitude d'au moins l'un des signaux $C_{min}$ et $C_{max}$ est réglable.

7. Système potentiométrique selon l'une quelconque des revendications précédentes, caractérisé en ce que le second signal délivré par le premier circuit de transformation (20) est une suite d'impulsions et ladite caractéristique variable en fonction de la position de l'organe mobile est le rapport cyclique desdites impulsions.

8. Système potentiométrique selon la revendication 7, caractérisé en ce que le premier circuit de transformation (20) comporte : un générateur (23) d'un signal en dents de scie variant entre une valeur minimale et une valeur maximale prédéterminées, un additionneur (22) recevant sur une première entrée le signal en dents de scie et sur une seconde entrée un signal dont l'amplitude varie en fonction de la position de l'organe mobile et les additionnant pour fournir un signal somme, et un comparateur (24) qui reçoit le signal somme et un signal représentant une valeur de référence prédéterminée et dont la sortie est dans un premier ou un second état selon que le signal somme est ou non supérieur à la valeur de référence.

9. Système potentiométrique selon la revendication 8, caractérisé en ce que la valeur de référence est supérieure à la somme de la valeur maximale du signal en dents de scie et de la valeur minimale du signal appliqué à la seconde entrée de l'additionneur (22).

10. Système potentiométrique selon l'une quelconque des revendications 8 et 9, caractérisé en ce que la valeur de référence est inférieure à la somme de la valeur minimale du signal en dents de scie et de la valeur maximale du signal appliqué à la seconde entrée de l'additionneur (22).

11. Système potentiométrique selon l'une quelconque des revendications 8 à 10, caractérisé en ce que le signal appliqué à la seconde entrée de l'additionneur (22) est ledit premier signal d'amplitude x.

12. Système potentiométrique selon l'une quelconque des revendications 8 à 10, caractérisé en ce qu'un générateur de fonction (21) est relié à la seconde entrée de l'aditionneur (22), ce générateur de fonction recevant ledit premier signal d'amplitude x et délivrant un signal dont l'amplitude varie en fonction de x suivant une fonction donnée.

13. Système potentiométrique selon l'une quelconque des revendications 8 à 12, caractérisé en ce que ladite valeur de référence est réglable.

14. Système potentiométrique selon l'une quelconque des revendications 8 à 13, caractérisé en ce que l'amplitude entre les valeurs minimale du signal en dents de scie est réglable.

15. Système potentiométrique selon l'une quelconque des revendications 7 à 14, caractérisé en ce que le second circuit de transformation (30) comporte : un circuit soustracteur (31) recevant les signaux représentatifs de $C_{min}$ et $C_{max}$ pour délivrer un signal représentatif de $C_{max} - C_{min}$ ; un circuit interrupteur (34) dont la fermeture est commandée par les impulsions du second signal fourni par le premier circuit de transformation ; un circuit additionneur (35) ayant une entrée recevant le signal représentatif de $C_{min}$ et une autre entrée reliée à la sortie du circuit soustracteur par l'intermédiaire du circuit interrupteur ; et un circuit de sortie (36) délivrant ladite grandeur C sous forme d'un signal continu dont l'amplitude représente la valeur moyenne du signal fourni par le circuit additionneur (35).

## Claims

1. Improved potentiometric system for converting the position of a movable member (10) into an electrical parameter C which varies in dependence upon a predetermined law f between a predetermined minimum value $C_{min}$ and a maximum value $C_{max}$, when the movable member is displaced from a first to a second end position, the said movable member being connected to a slide contact (11) of a mechanical potentiometer (12) which outputs a first signal of variable amplitude x as a function of the position of the movable member, characterized in that a first converter circuit (20) receives the said first signal of amplitude x in order to convert it into a second signal (z) of which a characteristic varies as a function of x in accordance with the said predetermined law f between a minimum value k and a maximum value K when the movable member is displaced from its first ($\alpha_0$) to its second position ($\alpha_M$), and a second converter circuit (30) receives the said second signal and two signals representing the values $C_{min}$ and $C_{max}$ in order to output the said value

$$C = C_{min} + [(C_{max} - C_{min})/(K - k)] \, [f(x) - k] \, .$$

2. Potentiometric system according to claim 1 characterized in that the first converter circuit (20) comprises means for maintaining at the null value the said characteristic of the second signal when the movable member (10) is displaced over a range lying between its first end position ($\alpha_0$) and a first intermediate position ($\alpha_1$).

3. Potentiometric system according to any one of claims 1 to 3, characterized in that the first converter circuit (20) comprises control means for adjusting the location of the said first intermediate position ($\alpha_1$).

4. Potentiometric system according to any one of claims 1 to 3, characterized in that the first converter circuit (20) comprises means for maintaining at the value K the said characteristic of the second signal when the movable member (10) is displaced within a range lying between a second intermediate position ($\alpha_2$) and its second end position ($\alpha_M$).

5. Potentiometric system according to claim 4, characterized in that the first converter circuit (20) comprises control means for adjusting the location of the said second intermediate position ($\alpha_2$).

6. Potentiometric system according to any one of the preceding claims, characterized in that the amplitude of at least one of the signals $C_{min}$ and $C_{max}$ is adjustable.

7. Potentiometric system according to any one of the preceding claims, characterized in that the second signal output by the first converter circuit (20) is a series of pulses and the said characteristic variable as a function of the position of the movable member is the duly cycle of the said pulses.

8. Potentiometric system according to claim 7, characterized in that the first converter circuit (20) comprises : a saw tooth generator (23) varying between a predetermined minimum value and a predetermined maximum value, an adder (22) receiving at a first input the saw tooth signal and at a second input a signal of which the amplitude varies as a function of the position of the movable member and adds them in order to generate a sum signal, and a comparator (24) which receives the sum signal and a signal representing a predetermined reference value and of which the output is in a first or a second state according as the sum signal is or is not greater than the reference value.

9. Potentiometric system according to claim 8, characterized in that the reference value is greater than the sum of the maximum value of the saw tooth signal and of the minimum value of the signal applied to the second input of the adder (22).

10. Potentiometric system according to any one of claims 8 and 9, characterized in that the reference value is less than the sum of the minimum value of the saw tooth signal and of the maximum value of the signal applied to the second input of the adder (22).

11. Potentiometric system according to any one of claims 8 to 10, characterized in that the signal applied to the second input of the adder (22) is the said first signal of amplitude x.

12. Potentiometric system according to any one of claims 8 to 10, characterized in that a function generator (21) is connected to the second input of the adder (22), this function generator receiving the said first signal of amplitude x and supplying a signal of which the amplitude varies as a function of x in accordance with a given function.

13. Potentiometric system according to any one of claims 8 to 12, characterized in that the said reference value is adjustable.

14. Potentiometric system according to any one of claims 8 to 13, characterized in that the amplitude between the minimum and maximum values of the saw tooth signal is adjustable.

15. Potentiometric system according to any one of claims 7 to 14, characterized in that the second converter circuit (30) comprises : a subtraction circuit (31) receiving the signals representative of $C_{min}$ and $C_{max}$ in order to deliver a signal re[resemtatove pf $C_{max} - C_{min}$ ; an interrupter circuit (34) of which the closure is controlled by the pulses of the second signal provided by the first converter circuit ; an adder circuit (35) having an input receiving the signal representative of $C_{min}$ and a further input connected to the output of the subtraction circuit through the intermediary of the interrupter circuit ; and an output circuit (36) delivering the said parameter C in the form of a continuous signal of which the amplitude represents the mean value of the signal supplied by the adder circuit (35).

**Ansprüche**

1. Potentiometersystem zur Umwandlung der Position eines beweglichen Organs (10) in eine elektrische Größe (C), die nach einer vorbestimmten Gesetzmäßigkeit [f(x)] zwischen einem vorbestimmten Minimalwert ($C_{min}$) und einem vorbestimmten Maximalwert ($C_{max}$) variiert, wenn das bewegliche Organ (10) von einer ersten in eine zweite Extremstellung bewegt wird, wobei das bewegliche Organ (10) mit dem Läufer (11) eines mechanischen Potentiometers (12) verbunden ist, das ein erstes Signal liefert, dessen Amplitude (x) eine Funktion der Postion des beweglichen Organs (10) ist, gekennzeichnet durch eine erste Wandlerschaltung (20), der das erste Signal mit der genannten Amplitude (x) zuführbar ist und die zur Umwandlung dieses Signals in ein zweites Signal (z) mit einer charakteristischen Größe dient, welche sich als Funktion von der Amplitude (x) nach der genannten vorbestimmten Gesetzmäßigkeit zwischen einem Mindestwert (k) und einem Höchstwert (K) ändert, wenn das bewegliche Organ aus seiner ersten ($\alpha_0$) in seine zweite Extremstellung ($\alpha_M$) bewegt wird, sowie eine zweite Wandlerschaltung (30), der das genannte zweite Signal (z) sowie zwei weitere für den Minimalwert ($C_{min}$) bzw. den Maximalwert ($C_{max}$) kennzeichnende Signale zuführbar sind und die zur Erzeugung der genannten elektrischen Größe

$$C = C_{min} + [(C_{max} - C_{min})/(K - k)] \, [f(x) - k]$$

dient.

2. Potentiometersystem nach Anspruch 1, dadurch gekennzeichnet, daß die erste Wandlerschaltung (20) Mittel aufweist, durch die die genannte charakteristische größe des zweiten Signals (z) auf dem Wert Null gehalten wird, wenn das bewegliche Organ (10) in einem Bereich bewegt wird, der zwischen seiner ersten Extremstellung ($\alpha_0$) und einer ersten Zwischenstellung ($\alpha_1$) liegt.

3. Potentiometersystem nach Anspruch 1 oder 2, dadurch gekennzeichnet, daß die erste Wandlerschaltung (20) Stellmittel aufweist, durch die der Ort der genannten ersten Zwischenstellung ($\alpha_1$) einstellbar ist.

4. Potentiometersystem nach einem der Ansprüche 1 bis 3, dadurch gekennzeichnet, daß die erste Wandlerschaltung (20) Mittel aufweist, durch die die charakteristische Größe des zweiten Signals dem genannten Höchstwert (K) gehalten wird, wenn das bewegliche Organ (10) in einem Bereich bewegt wird, der zwischen einer zweiten Zwischenstellung ($\alpha_2$) und der zweiten Extremstellung ($\alpha_M$) liegt.

5. Potentiometersystem nach Anspruch 4, dadurch gekennzeichnet, daß die erste Wandlerschaltung (20) Stellmittel aufweist, durch die der Ort der genannten zweiten Zwischenstellung ($\alpha_2$) einstellbar ist.

6. Potentiometersystem nach einem der vorhergehenden Ansprüche, dadurch gekennzeichnet, daß die Amplitude wenigstens einer der Extremwerte ($C_{min}$ oder $C_{max}$) des elektrischen Signals regelbar ist.

7. Potentiometersystem nach einem der vorhergehenden Ansprüche, dadurch gekennzeichnet, daß das von der ersten Wandlerschaltung (20) gelieferte zweite Signal (z) eine Impulsfolge ist und daß die genannte in Abhängigkeit von der Position des beweglichen Organs veränderbare charakteristische Größe das Zyklusverhältnis der Impulse dieser Impulsfolge ist.

8. Potentiometersystem nach Anspruch 7, dadurch gekennzeichnet, daß die erste Wandlerschaltung (20) folgende Teile umfaßt einen Generator (23) zur Erzeugung eines Sägezahnsignals, das sich zwischen einem vorbestimmten Mindestwert und einem vorbestimmten Höchstwert ändert, einen Addierer (22), dem an einem ersten Eingang das Sägezahnsignal und an einem zweiten Eingang ein Signal mit von der Position des beweglichen Organs abhängiger Amplitude zugeführt wird und der diese Signale addiert und ein entsprechendes Summensignal liefert, sowie einen Komparator (24), dem das Summensignal sowie ein einen vorbestimmten Referenzwert repräsentierendes Signal zugeführt werden und dessen Ausgang sich in Abhängigkeit davon, ob das Summensignal größer oder kleiner ist als der Referenzwert, entweder in einem ersten oder in einem zweiten Signalzustand befindet.

9. Potentiometersystem nach Anspruch 8, dadurch gekennzeichnet, daß der Referenzwert größer ist als die Summe des Höchstwerts des Sägezahnsignals und des Minimalwerts des an dem zweiten Eingang des Addierers (22) anliegenden Signals.

10. Potentiometersystem nach einem der Ansprüche 8 oder 9, dadurch gekennzeichnet, daß der Referenzwert kleiner ist als die Summe des Mindestwerts des Sägezahnsignals und des Maximalwerts des an dem zweiten Eingang des Addierers (22) anliegenden Signals.

11. Potentiometersystem nach einem der Ansprüche 8 bis 10, dadurch gekennzeichnet, daß das an dem zweiten Eingang des Addierers (22) anliegende Signal das genannte erste Signal ist, dessen Amplitude (x) eine Funktion der Postion des beweglichen Organs (10) ist.

12. Potentiometersystem nach einem der Ansprüche 8 bis 10, dadurch gekennzeichnet, daß mit dem zweiten Eingang des Addierers (22) ein Funktionsgenerator (21) verbunden ist, an welchem das genannte erste Signal anliegt, dessen Amplitude (x) eine Funktion der Postion des beweglichen Organs (10) ist, und daß dieser Funktionsgenerator ein Signal liefert, dessen Amplitude sich in Abhängigkeit von der genannten Amplitude (x) gemäß einer vorgegebenen Funktion ändert.

13. Potentiometersystem nach einem der Ansprüche 8 bis 12, dadurch gekennzeichnet, daß der genannte Referenzwert regulierbar ist.

14. Potentiometersystem nach einem der Ansprüche 8 bis 13, dadurch gekennzeichnet, daß die Amplitude zwischen dem Mindestwert und dem Höchstwert des Sägezahnsignals regulierbar ist.

15. Potentiometersystem nach einem der Ansprüche 7 bis 14, dadurch gekennzeichnet, daß die zweite Wandlerschaltung (30) folgende Teile umfaßt einen Subtrahierer (21), dem die für die Extremwerte

7

**0 065 901**

(C_{min} und C_{max}) der elektrischen Größe kennzeichnenden Signale zuführbar sind und der ein die Differenz ($C_{max} - C_{min}$) kennzeichnendes Signal liefert, einen Schalter (34), dessen Schließen durch die Impulse des von der ersten Wandlerschaltung (20) gelieferten zweiten Signals (z) steuerbar ist, einen Addierer (35), dem an einem Eingang das für den Minimalwert (C_{min}) kennzeichnende Signal zuführbar ist und mit einem anderen Eingang über den Schalter (34) mit dem Ausgang des Subtrahierers (31) verbunden ist, sowie eine Ausgangsschaltung (36), die die genannte Größe (C) in Form eines kontinuierlichen Signals liefert, dessen Amplitude dem Mittelwert des von dem Addierer (35) gelieferten Signals entspricht.

FIG.1

FIG.2

FIG.3

FIG. 7

FIG. 6

FIG. 5

FIG. 4

2

FIG. 8

FIG. 9

FIG. 10

FIG. 11